# EUROPEAN PATENT APPLICATION

(11) **EP 4 622 147 A1**
(43) Date of publication of application: **24.09.2025**
(21) Application number: 25164852.3
(22) Date of filing: 19.03.2025
(51) Int. Cl.: H04L 1/00, H03M 13/11, H04L 27/34, H03M 13/25, H03M 13/27, H03M 13/29, H03M 13/09

(54) **CODED MODULATION IN COMMUNICATIONS**

(30) Priority: 21.03.2024 FI 20245324
(71) Applicant: Nokia Solutions and Networks Oy, 02610 Espoo (FI)
(72) Inventor: BATSHON, Hussam, Monroe Township, NJ (US)
(74) Representative: Nokia EPO representatives

(57) **Abstract**

Disclosed is a method comprising, by a transmitter apparatus, partitioning (901) an input data stream to obtain a bit stream X1 and a bit stream X2; subjecting (902) the bit stream X2 to encoding by LDPC encoders, to obtain X2 parity bits, and X2 information bits; applying (903) SPC encoding to the X2 parity bits, together with the bit stream X1, to obtain sign bits, wherein the bit stream X1 is used as padding bits; subjecting (904) the sign bits, the padding bits, and the X2 information bits, to an interleaver operation to obtain an interleaver output; subjecting (905) the interleaver output to Gray mapping to form multiple consecutive quadratic amplitude modulation, QAM, symbols; modulating (905) the QAM symbols by quadratic amplitude modulation to obtain a modulated data stream; and transmitting (906) the modulated data stream via a radio access network or optical fibre communication network.

## Description

### FIELD

The following example embodiments relate to network communications and to coded modulation.

### BACKGROUND

The initiation and establishment of 6G signifies a development in wireless communications, as 6G is anticipated to deliver unparalleled speeds, augmented bandwidths, and extensive connectivity. However, the migration to 6G introduces inherent challenges, some of which are not exclusive to wireless communication. The innovative attributes of 6G, including functionalities such as ultra-reliable low-latency communication (URLLC) and enhanced mobile broadband (eMBB), also present obstacles related to modulation, channel coding, and signal processing. These challenges underline the necessity for solutions capable of fulfilling the potential of 6G, without sacrificing efficiency or reliability.

### BRIEF DESCRIPTION

The scope of protection sought for various example embodiments is set out by the independent claims. The example embodiments and features, if any, described in this specification that do not fall under the scope of the independent claims are to be interpreted as examples useful for understanding various embodiments.

According to an aspect, there is provided an apparatus comprising at least one processor, and at least one memory storing instructions that, when executed by the at least one processor, cause the apparatus at least to:
partition an input data stream to obtain a first bit stream X1 and a second bit stream X2;
subject the second bit stream X2 to manipulation at least by encoding by an N number of identical low-density parity check (LDPC) encoders, to obtain X2 parity bits, and X2 information bits;
apply single parity check (SPC) encoding to the X2 parity bits, together with the first bit stream X1, to obtain sign bits, wherein the first bit stream X1 is used as padding bits;
subject the sign bits, the padding bits, and the X2 information bits, to an interleaver operation, wherein in the interleaver operation the sign bits, the padding bits, and the X2 information bits are written sequentially in a row-wise orientation into an interleaver matrix, and then read sequentially in a column-wise manner from the interleaver matrix to obtain an interleaver output;
subject the interleaver output to Gray mapping to form multiple consecutive quadratic amplitude modulation (QAM) symbols;
modulate the QAM symbols by quadratic amplitude modulation to obtain a modulated data stream; and
transmit the modulated data stream via a radio access network or optical fibre communication network.

According to another aspect, there is provided an apparatus comprising: means for
partitioning an input data stream to obtain a first bit stream X1 and a second bit stream X2;
subjecting the second bit stream X2 to manipulation at least by encoding by an N number of identical low-density parity check (LDPC) encoders, to obtain X2 parity bits, and X2 information bits;
applying single parity check (SPC) encoding to the X2 parity bits, together with the first bit stream X1, to obtain sign bits, wherein the first bit stream X1 is used as padding bits;
subjecting the sign bits, the padding bits, and the X2 information bits, to an interleaver operation, wherein in the interleaver operation the sign bits, the padding bits, and the X2 information bits are written sequentially in a row-wise orientation into an interleaver matrix, and then read sequentially in a column-wise manner from the interleaver matrix to obtain an interleaver output;
subjecting the interleaver output to Gray mapping to form multiple consecutive quadratic amplitude modulation (QAM) symbols;
modulating the QAM symbols by quadratic amplitude modulation to obtain a modulated data stream; and
transmitting the modulated data stream via a radio access network or optical fibre communication network.

According to another aspect, there is provided a method comprising:
partitioning an input data stream to obtain a first bit stream X1 and a second bit stream X2;
subjecting the second bit stream X2 to manipulation at least by encoding by an N number of identical low-density parity check (LDPC) encoders, to obtain X2 parity bits, and X2 information bits;
applying single parity check (SPC) encoding to the X2 parity bits, together with the first bit stream X1, to obtain sign bits, wherein the first bit stream X1 is used as padding bits;
subjecting the sign bits, the padding bits, and the X2 information bits, to an interleaver operation, wherein in the interleaver operation the sign bits, the padding bits, and the X2 information bits are written sequentially in a row-wise orientation into an interleaver matrix, and then read sequentially in a column-wise manner from the interleaver matrix to obtain an interleaver output;
subjecting the interleaver output to Gray mapping to form multiple consecutive quadratic amplitude modulation (QAM) symbols;
modulating the QAM symbols by quadratic amplitude modulation to obtain a modulated data stream; and
transmitting the modulated data stream via a radio access network or optical fibre communication network.

According to another aspect, there is provided a computer program comprising instructions which, when executed by an apparatus, cause the apparatus to perform at least the following:
partition an input data stream to obtain a first bit stream X1 and a second bit stream X2;
subject the second bit stream X2 to manipulation at least by encoding by an N number of identical low-density parity check (LDPC) encoders, to obtain X2 parity bits, and X2 information bits;
apply single parity check (SPC) encoding to the X2 parity bits, together with the first bit stream X1, to obtain sign bits, wherein the first bit stream X1 is used as padding bits;
subject the sign bits, the padding bits, and the X2 information bits, to an interleaver operation, wherein in the interleaver operation the sign bits, the padding bits, and the X2 information bits are written sequentially in a row-wise orientation into an interleaver matrix, and then read sequentially in a column-wise manner from the interleaver matrix to obtain an interleaver output;
subject the interleaver output to Gray mapping to form multiple consecutive quadratic amplitude modulation (QAM) symbols;
modulate the QAM symbols by quadratic amplitude modulation to obtain a modulated data stream; and
transmit the modulated data stream via a radio access network or optical fibre communication network.

According to another aspect, there is provided a computer readable medium comprising program instructions which, when executed by an apparatus, cause the apparatus to perform at least the following:
partition an input data stream to obtain a first bit stream X1 and a second bit stream X2;
subject the second bit stream X2 to manipulation at least by encoding by an N number of identical low-density parity check (LDPC) encoders, to obtain X2 parity bits, and X2 information bits;
apply single parity check (SPC) encoding to the X2 parity bits, together with the first bit stream X1, to obtain sign bits, wherein the first bit stream X1 is used as padding bits;
subject the sign bits, the padding bits, and the X2 information bits, to an interleaver operation, wherein in the interleaver operation the sign bits, the padding bits, and the X2 information bits are written sequentially in a row-wise orientation into an interleaver matrix, and then read sequentially in a column-wise manner from the interleaver matrix to obtain an interleaver output;
subject the interleaver output to Gray mapping to form multiple consecutive quadratic amplitude modulation (QAM) symbols;
modulate the QAM symbols by quadratic amplitude modulation to obtain a modulated data stream; and
transmit the modulated data stream via a radio access network or optical fibre communication network.

According to another aspect, there is provided a non-transitory computer readable medium comprising program instructions which, when executed by an apparatus, cause the apparatus to perform at least the following:
partition an input data stream to obtain a first bit stream X1 and a second bit stream X2;
subject the second bit stream X2 to manipulation at least by encoding by an N number of identical low-density parity check (LDPC) encoders, to obtain X2 parity bits, and X2 information bits;
apply single parity check (SPC) encoding to the X2 parity bits, together with the first bit stream X1, to obtain sign bits, wherein the first bit stream X1 is used as padding bits;
subject the sign bits, the padding bits, and the X2 information bits, to an interleaver operation, wherein in the interleaver operation the sign bits, the padding bits, and the X2 information bits are written sequentially in a row-wise orientation into an interleaver matrix, and then read sequentially in a column-wise manner from the interleaver matrix to obtain an interleaver output;
subject the interleaver output to Gray mapping to form multiple consecutive quadratic amplitude modulation (QAM) symbols;
modulate the QAM symbols by quadratic amplitude modulation to obtain a modulated data stream; and
transmit the modulated data stream via a radio access network or optical fibre communication network.

According to another aspect, there is provided an apparatus comprising at least one processor, and at least one memory storing instructions that, when executed by the at least one processor, cause the apparatus at least to:
demodulate a data stream received by the apparatus via a radio access network or optical fibre communication network, to obtain a demodulated data stream;
demap the demodulated data stream by a soft-input/soft-output maximum a posteriori (SISO-MAP) decoder, or by a multidimensional soft demapper, to obtain a demapped data stream and bit log-likelihood ratios (LLRs);
subject the demapped data stream to a deinterleaver operation, wherein in the deinterleaver operation bits of the demapped data stream are written sequentially in a column-wise orientation into a deinterleaver matrix, and then the bits are read sequentially in a row-wise manner from the deinterleaver matrix to obtain a deinterleaver output; and
subject the deinterleaver output to a forward error correction (FEC) process by feeding the deinterleaver output and the bit log-likelihood ratios (LLRs) to an N number of identical low-density parity check (LDPC), decoders.

According to another aspect, there is provided an apparatus comprising: means for
demodulating a data stream received by the apparatus via a radio access network or optical fibre communication network, to obtain a demodulated data stream;
demapping the demodulated data stream by a soft-input/soft-output maximum a posteriori (SISO-MAP) decoder, or by a multidimensional soft demapper, to obtain a demapped data stream and bit log-likelihood ratios (LLRs);
subjecting the demapped data stream to a deinterleaver operation, wherein in the deinterleaver operation bits of the demapped data stream are written sequentially in a column-wise orientation into a deinterleaver matrix, and then the bits are read sequentially in a row-wise manner from the deinterleaver matrix to obtain a deinterleaver output; and
subjecting the deinterleaver output to a forward error correction (FEC) process by feeding the deinterleaver output and the bit log-likelihood ratios (LLRs) to an N number of identical low-density parity check (LDPC) decoders.

According to another aspect, there is provided a method comprising:
demodulating a data stream received by the apparatus via a radio access network or optical fibre communication network, to obtain a demodulated data stream;
demapping the demodulated data stream by a soft-input/soft-output maximum a posteriori (SISO-MAP) decoder, or by a multidimensional soft demapper, to obtain a demapped data stream and bit log-likelihood ratios (LLRs);
subjecting the demapped data stream to a deinterleaver operation, wherein in the deinterleaver operation bits of the demapped data stream are written sequentially in a column-wise orientation into a deinterleaver matrix, and then the bits are read sequentially in a row-wise manner from the deinterleaver matrix to obtain a deinterleaver output; and
subjecting the deinterleaver output to a forward error correction (FEC) process by feeding the deinterleaver output and the bit log-likelihood ratios (LLRs) to an N number of identical low-density parity check (LDPC) decoders.

According to another aspect, there is provided a computer program comprising instructions which, when executed by an apparatus, cause the apparatus to perform at least the following:
demodulate a data stream received by the apparatus via a radio access network or optical fibre communication network, to obtain a demodulated data stream;
demap the demodulated data stream by a soft-input/soft-output maximum a posteriori (SISO-MAP) decoder, or by a multidimensional soft demapper, to obtain a demapped data stream and bit log-likelihood ratios (LLRs);
subject the demapped data stream to a deinterleaver operation, wherein in the deinterleaver operation bits of the demapped data stream are written sequentially in a column-wise orientation into a deinterleaver matrix, and then the bits are read sequentially in a row-wise manner from the deinterleaver matrix to obtain a deinterleaver output; and
subject the deinterleaver output to a forward error correction (FEC) process by feeding the deinterleaver output and the bit log-likelihood ratios (LLRs) to an N number of identical low-density parity check (LDPC) decoders.

According to another aspect, there is provided a computer readable medium comprising program instructions which, when executed by an apparatus, cause the apparatus to perform at least the following:
demodulate a data stream received by the apparatus via a radio access network or optical fibre communication network, to obtain a demodulated data stream;
demap the demodulated data stream by a soft-input/soft-output maximum a posteriori (SISO-MAP) decoder, or by a multidimensional soft demapper, to obtain a demapped data stream and bit log-likelihood ratios (LLRs);
subject the demapped data stream to a deinterleaver operation, wherein in the deinterleaver operation bits of the demapped data stream are written sequentially in a column-wise orientation into a deinterleaver matrix, and then the bits are read sequentially in a row-wise manner from the deinterleaver matrix to obtain a deinterleaver output; and
subject the deinterleaver output to a forward error correction (FEC) process by feeding the deinterleaver output and the bit log-likelihood ratios (LLRs) to an N number of identical low-density parity check (LDPC) decoders.

According to another aspect, there is provided a non-transitory computer readable medium comprising program instructions which, when executed by an apparatus, cause the apparatus to perform at least the following:
demodulate a data stream received by the apparatus via a radio access network or optical fibre communication network, to obtain a demodulated data stream;
demap the demodulated data stream by a soft-input/soft-output maximum a posteriori (SISO-MAP) decoder, or by a multidimensional soft demapper, to obtain a demapped data stream and bit log-likelihood ratios (LLRs);
subject the demapped data stream to a deinterleaver operation, wherein in the deinterleaver operation bits of the demapped data stream are written sequentially in a column-wise orientation into a deinterleaver matrix, and then the bits are read sequentially in a row-wise manner from the deinterleaver matrix to obtain a deinterleaver output; and
subject the deinterleaver output to a forward error correction (FEC) process by feeding the deinterleaver output and the bit log-likelihood ratios (LLRs) to an N number of identical low-density parity check (LDPC) decoders.

### LIST OF DRAWINGS

In the following, various example embodiments will be described in greater detail with reference to the accompanying drawings, in which
FIG. 1 illustrates an example of a communications network;
FIG. 2 illustrates an exemplary transmitter and receiver architecture;
FIG. 3 illustrates SPC coded 4D modulation;
FIG. 4 illustrates valid symbol combinations for SPC(3,4) - 64QAM and SPC(3,4) - PS64QAM;
FIG. 5 illustrates exemplary interleaver operation;
FIGs. 6A and 6B illustrate exemplary FEC frame structure and interleaver operation for SPC(3,4) - 64QAM;
FIGs. 7A, 7B, 7C and 7D illustrate network performance improvement utilizing SPC coding;
FIG. 8 illustrates an exemplary process utilizing PS and MDCM-ID;
FIGs. 9 and 10 illustrate an embodiment of carrying out the process of FIG. 8;
FIG. 11 illustrates a block diagram of a structure of an apparatus according to an embodiment.

### DETAILED DESCRIPTION

The following embodiments are exemplifying. Although the specification may refer to "an", "one", or "some" embodiment(s) in several locations of the text, this does not necessarily mean that each reference is made to the same embodiment(s), or that a particular feature only applies to a single embodiment. Single features of different embodiments may also be combined to provide other embodiments.

Some example embodiments described herein may be implemented in a wireless communication network comprising a radio access network based on one or more of the following radio access technologies (RATs): Global System for Mobile Communications (GSM) or any other second generation radio access technology, Universal Mobile Telecommunication System (UMTS, 3G) based on basic wideband-code division multiple access (W-CDMA), high-speed packet access (HSPA), Long Term Evolution (LTE), LTE-Advanced, fourth generation (4G), fifth generation (5G), 5G new radio (NR), 5G-Advanced (i.e., 3GPP NR Rel-18 and beyond), or sixth generation (6G). Some examples of radio access networks include the universal mobile telecommunications system (UMTS) radio access network (UTRAN), the Evolved Universal Terrestrial Radio Access network (E-UTRA), or the next generation radio access network (NG-RAN). The wireless communication network may further comprise a core network, and some example embodiments may also be applied to network functions of the core network.

It should be noted that the embodiments are not restricted to the wireless communication network given as an example, but a person skilled in the art may also apply the solution to other wireless communication networks or systems provided with necessary properties. For example, some example embodiments may also be applied to a communication system based on IEEE 802.11 specifications, or a communication system based on IEEE 802.15 specifications. IEEE is an abbreviation for the Institute of Electrical and Electronics Engineers.

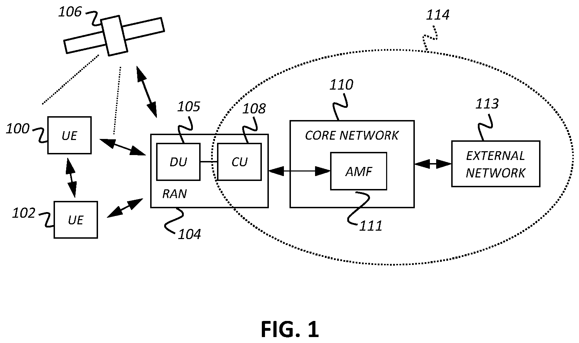

FIG. 1 depicts an example of a simplified wireless communication network showing some physical and logical entities. The connections shown in FIG. 1 may be physical connections or logical connections. It is apparent to a person skilled in the art that the wireless communication network may also comprise other physical and logical entities than those shown in FIG. 1.

The example embodiments described herein are not, however, restricted to the wireless communication network given as an example but a person skilled in the art may apply the example embodiments described herein to other wireless communication networks provided with necessary properties.

The example wireless communication network shown in FIG. 1 includes a radio access network (RAN) and a core network 110.

FIG. 1 shows user equipment (UE) 100, 102 configured to be in a wireless connection on one or more communication channels in a radio cell with an access node 104 of a radio access network.

The access node 104 may comprise a computing device configured to control the radio resources of the access node 104 and to be in a wireless connection with one or more UEs 100, 102. The access node 104 may also be referred to as a base station, a base transceiver station (BTS), an access point, a cell site, a network node, a radio access network node, or a RAN node. The access node 104 may be, for example, an evolved NodeB (abbreviated as eNB or eNodeB), or a next generation evolved NodeB (abbreviated as ng-eNB), or a next generation NodeB (abbreviated as gNB or gNodeB), providing the radio cell. The access node 104 may include or be coupled to transceivers. From the transceivers of the access node 104, a connection may be provided to an antenna unit that establishes a bi-directional radio link to one or more UEs 100, 102. The antenna unit may comprise an antenna or antenna element, or a plurality of antennas or antenna elements.

The wireless connection (e.g., radio link) from a UE 100, 102 to the access node 104 may be called uplink (UL) or reverse link, and the wireless connection (e.g., radio link) from the access node 104 to the UE 100, 102 may be called downlink (DL) or forward link. A UE 100 may also communicate directly with another UE 102, and vice versa, via a wireless connection generally referred to as a sidelink (SL). It should be appreciated that the access node 104 or its functionalities may be implemented by using any node, host, server, access point or other entity suitable for providing such functionalities.

The radio access network may comprise more than one access node 104, in which case the access nodes may also be configured to communicate with one another over wired or wireless links. These links between access nodes may be used for sending and receiving control plane signaling and also for routing data from one access node to another access node.

The access node 104 may further be connected to a core network (CN) 110. The core network 110 may comprise an evolved packet core (EPC) network and/or a 5^{th} generation core network (5GC) and/or a 6^{th} generation core network. The EPC may comprise network entities, such as a serving gateway (S-GW for routing and forwarding data packets), a packet data network gateway (P-GW) for providing connectivity of UEs to external packet data networks, and/or a mobility management entity (MME). The core network may comprise one or more network functions, such as at least one of: an access and mobility management function (AMF) 111, a user plane function (UPF), a location management function (LMF), and/or a session management function (SMF).

The core network 110 may also be able to communicate with one or more external networks 113, such as a public switched telephone network or the Internet, or utilize services provided by them. For example, in 5G wireless communication networks, the UPF of the core network 110 may be configured to communicate with an external data network via an N6 interface. In LTE wireless communication networks, the P-GW of the core network 110 may be configured to communicate with an external data network.

It should also be understood that the distribution of functions between core network operations and access node operations may differ in future wireless communication networks compared to that of the LTE, 5G or 6G, or even be non-existent.

The illustrated UE 100, 102 is one type of an apparatus to which resources on the air interface may be allocated and assigned. The UE 100, 102 may also be called a wireless communication device, a subscriber unit, a mobile station, a remote terminal, an access terminal, a user terminal, a terminal device, or a user device, just to mention but a few names. The UE 100, 102 may be a computing device operating with or without a subscriber identification module (SIM), including, but not limited to, the following types of computing devices: a mobile phone, a smartphone, a personal digital assistant (PDA), a handset, a computing device comprising a wireless modem (e.g., an alarm or measurement device, etc.), a laptop computer, a desktop computer, a tablet, a game console, a notebook, a multimedia device, a reduced capability (RedCap) device, a wearable device (e.g., a watch, earphones or eyeglasses) with radio parts, a sensor comprising a wireless modem, or a computing device comprising a wireless modem integrated in a vehicle.

It should be appreciated that the UE 100, 102 may also be a nearly exclusive uplink-only device, of which an example may be a camera or video camera loading images or video clips to a network. The UE 100, 102 may also be a device having capability to operate in an Internet of Things (IoT) network, which is a scenario in which objects may be provided with the ability to transfer data over a network without requiring human-to-human or human-to-computer interaction.

The wireless communication network may also be able to support the usage of cloud services. For example, at least part of core network operations may be carried out as a cloud service (this is depicted in FIG. 1 by "cloud" 114). The UE 100, 102 may also utilize the cloud 114. In some applications, the computation for a given UE may be carried out in the cloud 114 or in another UE.

The wireless communication network may also comprise a central control entity, such as a network management system (NMS), or the like. The NMS is a centralized suite of software and hardware used to monitor, control, and administer the network infrastructure. The NMS is responsible for a wide range of tasks such as fault management, configuration management, security management, performance management, and accounting management. The NMS enables network operators to efficiently manage and optimize network resources, ensuring that the network delivers high performance, reliability, and security.

5G enables using multiple-input and multiple-output (MIMO) antennas in the access node 104 and/or the UE 100, 102, many more base stations or access nodes than an LTE network (a so-called small cell concept), including macro sites operating in co-operation with smaller stations and employing a variety of radio technologies depending on service needs, use cases and/or spectrum available. 5G wireless communication networks may support a wide range of use cases and related applications including video streaming, augmented reality, different ways of data sharing and various forms of machine-type applications, such as (massive) machine-type communications (mMTC), including vehicular safety, different sensors and real-time control.

In 5G wireless communication networks, access nodes and/or UEs may have multiple radio interfaces, such as below 6 gigahertz (GHz), centimeter wave (cmWave) and millimeter wave (mmWave), and also being integrable with legacy radio access technologies, such as LTE. Integration with LTE may be implemented, for example, as a system, where macro coverage may be provided by LTE, and 5G radio interface access may come from small cells by aggregation to LTE. In other words, a 5G wireless communication network may support both inter-RAT operability (such as interoperability between LTE and 5G) and inter-RI operability (inter-radio interface operability, such as between below 6GHz, cmWave, and mmWave).

5G wireless communication networks may also apply network slicing, in which multiple independent and dedicated virtual sub-networks (network instances) may be created within the same physical infrastructure to run services that have different requirements on latency, reliability, throughput and mobility.

In one embodiment, an access node 104 may comprise: a radio unit (RU) comprising a radio transceiver (TRX), i.e., a transmitter (Tx) and a receiver (Rx); one or more distributed units (DUs) 105 that may be used for the so-called Layer 1 (L1) processing and real-time Layer 2 (L2) processing; and a central unit (CU) 108 (also known as a centralized unit) that may be used for non-real-time L2 and Layer 3 (L3) processing. The CU 108 may be connected to the one or more DUs 105 for example via an F1 interface. Such an embodiment of the access node 104 may enable the centralization of CUs relative to the cell sites and DUs, whereas DUs may be more distributed and may even remain at cell sites. The CU and DU together may also be referred to as baseband or a baseband unit (BBU). The CU and DU may also be comprised in a radio access point (RAP).

The CU 108 may be a logical node hosting radio resource control (RRC), service data adaptation protocol (SDAP) and/or packet data convergence protocol (PDCP), of the NR protocol stack for an access node 104. The CU 108 may comprise a control plane (CU-CP), which may be a logical node hosting the RRC and the control plane part of the PDCP protocol of the NR protocol stack for the access node 104. The CU 108 may further comprise a user plane (CU-UP), which may be a logical node hosting the user plane part of the PDCP protocol and the SDAP protocol of the CU for the access node 104.

The DU 105 may be a logical node hosting radio link control (RLC), medium access control (MAC) and/or physical (PHY) layers of the NR protocol stack for the access node 104. The operations of the DU 105 may be at least partly controlled by the CU 108. It should also be understood that the distribution of functions between the DU 105 and the CU 108 may vary depending on the implementation.

Cloud computing systems may also be used to provide the CU 108 and/or DU 105. A CU provided by a cloud computing system may be referred to as a virtualized CU (vCU). In addition to the vCU, there may also be a virtualized DU (vDU) provided by a cloud computing system. Furthermore, there may also be a combination, where the DU may be implemented on so-called bare metal solutions, for example application-specific integrated circuit (ASIC) or customer-specific standard product (CSSP) system-on-a-chip (SoC).

Edge cloud may be brought into the radio access network by utilizing network function virtualization (NFV) and software defined networking (SDN). Using edge cloud may mean access node operations to be carried out, at least partly, in a computing system operationally coupled to a remote radio head (RRH) or a radio unit (RU) of an access node 104. It is also possible that access node operations may be performed on a distributed computing system or a cloud computing system located at the access node 104. Application of cloud RAN architecture enables RAN real-time functions being carried out at the radio access network (e.g., in a DU 105), and non-real-time functions being carried out in a centralized manner (e.g., in a CU 108).

5G (or new radio, NR) wireless communication networks may support multiple hierarchies, where multi-access edge computing (MEC) servers may be placed between the core network 110 and the access node 104. It should be appreciated that MEC may be applied in LTE wireless communication networks as well.

A 5G wireless communication network ("5G network") may also comprise a non-terrestrial communication network, such as a satellite communication network, to enhance or complement the coverage of the 5G radio access network. For example, satellite communication may support the transfer of data between the 5G radio access network and the core network 110, enabling more extensive network coverage. Possible use cases may include: providing service continuity for machine-to-machine (M2M) or Internet of Things (IoT) devices or for passengers on board of vehicles, or ensuring service availability for critical communications, and future railway, maritime, or aeronautical communications. Satellite communication may utilize geostationary earth orbit (GEO) satellite systems, but also low earth orbit (LEO) satellite systems, in particular mega-constellations (i.e., systems in which hundreds of (nano)satellites are deployed). A given satellite 106 in the mega-constellation may cover several satellite-enabled network entities that create on-ground cells. The on-ground cells may be created through an on-ground relay access node or by an access node located on-ground or in a satellite.

It is obvious for a person skilled in the art that the access node 104 depicted in FIG. 1 is just an example of a part of a radio access network, and in practice the radio access network may comprise a plurality of access nodes 104, the UEs 100, 102 may have access to a plurality of radio cells, and the radio access network may also comprise other apparatuses, such as physical layer relay access nodes or other entities. At least one of the access nodes may be a Home eNodeB or a Home gNodeB. A Home gNodeB or a Home eNodeB is a type of access node that may be used to provide indoor coverage inside a home, office, or other indoor environment.

Additionally, in a geographical area of a radio access network, a plurality of different kinds of radio cells as well as a plurality of radio cells may be provided. Radio cells may be macro cells (or umbrella cells) which may be large cells having a diameter of up to tens of kilometers, or smaller cells such as micro-, femto- or picocells. The access node(s) 104 of FIG. 1 may provide any kind of these cells. A cellular radio network may be implemented as a multilayer access networks including several kinds of radio cells. In multilayer access networks, one access node may provide one kind of a radio cell or radio cells, and thus a plurality of access nodes may be needed to provide such a multilayer access network.

For fulfilling the need for improving performance of radio access networks, the concept of "plug-and-play" access nodes may be introduced. A radio access network, which may be able to use "plug-and-play" access nodes, may include, in addition to Home eNodeBs or Home gNodeBs, a Home Node B gateway (HNB-GW) (not shown in FIG. 1). An HNB-GW, which may be installed within an operator's radio access network, may aggregate traffic from a large number of Home eNodeBs or Home gNodeBs back to a core network 110 of the operator.

Some example embodiments are described below using principles and terminology of 5G radio access technology without limiting the example embodiments to 5G radio access technology, however. It should be noted that the embodiments are not restricted to the wireless communication network given as an example, but a person skilled in the art may also apply the solution to other wireless communication networks or systems provided with necessary properties. For example, some example embodiments may also be applied to a communication system based on 6G radio access technology or optical fiber transmission network.

Modulation techniques that were applicable and employed in 5G NR and earlier communication standards are reaching their operational bounds within the dynamic contexts of 5G NR. As a response, exploration into methodologies prevalent in optical communication, such as probabilistic shaping (PS) and coded modulation, is underway. By moving away from uniform signaling, PS fine-tunes the probability distribution of transmitted symbols, aligning them seamlessly with varying channel conditions to improve power efficiency and approach the theoretical limits of achievable rates. Nevertheless, in scenarios involving high throughput channels and high signal-to-noise ratio (SNR), PS might be less effective than multidimensional coded modulation (MDCM). By utilizing its multidimensional signal constellation, MDCM amplifies the advantages of PS, providing robust performance across a diverse spectrum of 6G channel SNRs.

In the context of 5G NR, 2-dimensional modulation formats such as binary phase shift keying (BPSK), QPSK, 16QAM, 64QAM, 256QAM, and 1024QAM are utilized. This selection excludes the adoption of coded modulation, multidimensional coded modulation, and constellation shaping (CS), leading to a limitation in the utilizable SNR range and the corresponding channel quality, thereby constraining the spectral efficiency (SE) at a specific SNR.

In contrast, optical communication systems frequently employ CS. CS represents an advanced modulation technique that adjusts the probability distribution of the constellation points within higher-order QAM formats, thereby enhancing the transmission reach and/or SE of the optical signal. Two primary methods to achieve CS exist: Probabilistic shaping (PS) and geometric shaping (GS). PS, characterized by a non-uniform distribution of symbol probabilities, enhances the power efficiency and potentially the spectral efficiency. Conversely, GS changes the actual positions of the constellation points.

Another advanced technique in optical communication is multidimensional coded modulation with iterative decoding (MDCM-ID). MDCM, in the context of optical communication, refers to the encoding of information not only in the amplitude and phase of the transmitted signal (as is typically done in standard QAM formats) but also in other degrees of freedom like time, polarization, or across different wavelengths. This approach increases the system's robustness against certain types of noise or distortion. In optical systems, it is common to use methods like time or polarization multiplexing. When paired with advanced modulation formats, these techniques may lead to a significant increase in overall data rate. The "iterative decoding, ID," part of MDCM-ID is a decoding process that makes multiple passes over the received data to enhance the accuracy of the decoded output. The decoder uses information from previous decoding iterations to refine its decision in subsequent iterations.

In existing solutions, the MDCM-ID and probabilistic shaping approaches are incompatible without introducing modifications to one or both, thereby preventing their direct combination.

The 5G NR standard does not incorporate coded modulation or probabilistic shaping. These techniques have been demonstrated to enhance the efficiency of data transmission across various channel conditions in optical communication. Without the integration of these techniques, 6G may not fully realize the potential spectral efficiency corresponding to specific channel states. In the 5G NR framework, adjustments to spectral efficiency are primarily managed in two ways as shown in Table 1. Table 1 shows modulation coding scheme (MCS) indexes (I_{MCS}) for physical downlink shared channel (PDSCH). The modulation and coding scheme (MCS) index is an industry metric based on several parameters of a wireless network connection between a client device and a wireless access point, including data rate, channel width, and the number of antennas or spatial streams in the device.

One solution may involve altering the modulation format which controls the number of bits transmitted per symbol, hence it has a significant impact on how much data is sent over the channel. For finer adjustments, the forward error correction (FEC) rate is modified. As FEC is used to enhance the reliability of data transmission, by varying its rate, one is able to trade-off between data throughput and robustness against errors. Although the combination of these two methods provides 5G NR with adaptability to diverse channel conditions, the introduction of coded modulation and probabilistic shaping could provide more granular control over spectral efficiency transitions, eliminating the need to modify the FEC code rate.

**Table 1. MCS index for PDSCH**

| MCS index *I_{MCS}* | Modulation order *Qₘ* | Target code rate *R* x [1024] | Spectral efficiency |
|---|---|---|---|
| 0 | 2 | 120 | 0.2344 |
| 1 | 2 | 193 | 0.3770 |
| 2 | 2 | 449 | 0.8770 |
| 3 | 4 | 378 | 1.4766 |
| 4 | 4 | 490 | 1.9141 |
| 5 | 4 | 616 | 2.4063 |
| 6 | 6 | 466 | 2.7305 |
| 7 | 6 | 517 | 3.0293 |
| ... | ... | ... | ... |
| 13 | 6 | 822 | 4.8164 |
| 14 | 6 | 873 | 5.1152 |
| 15 | 8 | 682.5 | 5.3320 |
| 16 | 8 | 711 | 5.5547 |
| ... | ,,, | ,,, | ,,, |
| 22 | 8 | 948 | 7.4063 |
| 23 | 10 | 805.5 | 7.8662 |
| ... | | | |
| 26 | 10 | 948 | 9.2578 |
| 27 | 2 | reserved | |
| 28 | 4 | reserved | |
| 29 | 6 | reserved | |
| 30 | 8 | reserved | |
| 31 | 10 | reserved | |

An embodiment introduces apparatuses and methods for implementing multidimensional coded modulation with iterative decoding (MDCM-ID), designed, for example, specifically for compatibility with probabilistic shaping (PS) in 6G applications. At lower SNRs, MDCM-ID increases sensitivity and enhances the performance of PS. Conversely, at higher SNRs associated with high throughput, MDCM-ID is able to operate in conjunction with uniformly distributed constellations. This approach provides a flexible and robust solution, addressing the diverse range of channel conditions expected in 6G communication systems. Regarding SNR, the thresholds for high and low vary with the modulation format size used. For example, what is considered 'low' SNR for a 64-QAM based modulation format may be 'moderate' to 'high' SNR for a 16-QAM based modulation format. The choice of modulation format is influenced by various factors, including channel conditions and performance requirements. The adaptability of MDCM-ID across different SNRs holds true for all modulation formats, but specifying exact values may be dependent on the specifics of the operational environment.

An embodiment enables to implement probabilistic shaping (PS) and MDCM-ID within optical communication systems and 5G NR. PS involves bit manipulation that as such is incompatible with MDCM-ID, in optical or radio transmission systems. An embodiment enables to integrate these two techniques to enhance overall performance. Thus, a combination of probabilistic shaping (PS) and MDCM-ID techniques is disclosed.

An embodiment utilizes two forward error correction codes: an outer code, implemented as a simple single parity check (SPC) code, and an inner code, utilizing a robust low-density parity check (LDPC) code. The outer code may be applied exclusively to sign bits, facilitating iterative decoding, improving the demapper's decision quality, and crucially avoiding interference with probabilistic amplitude shaping (PAS) if implemented.

An embodiment enables the integration of probabilistic shaping with iterative decoding by using an SPC coding scheme that is applied exclusively to the sign bits, in conjunction with a uniquely designed interleaver. This enables compatibility with the 6G technology and 6G standard, particularly in conjunction with short LDPC codes. An embodiment may also be applicable in the context of long-haul optical transmission when paired with long LDPC codes.

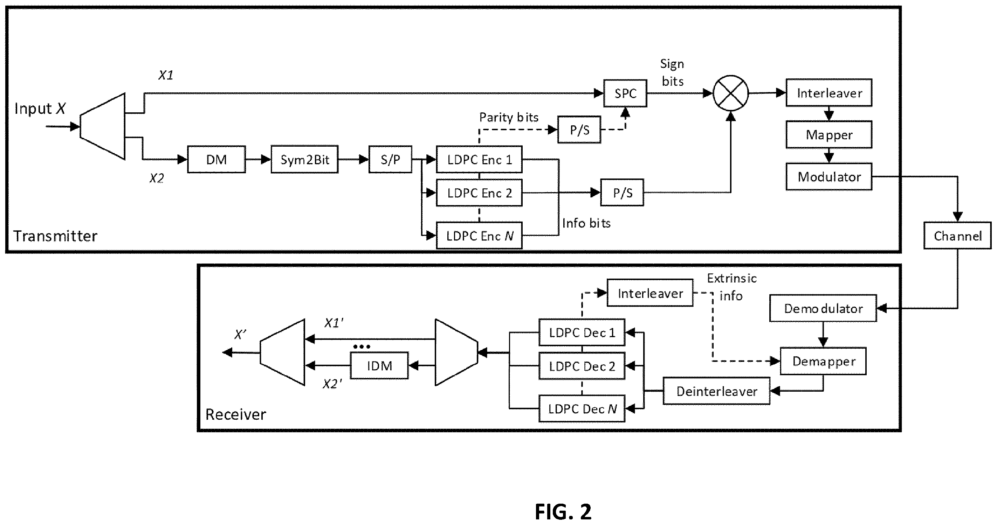

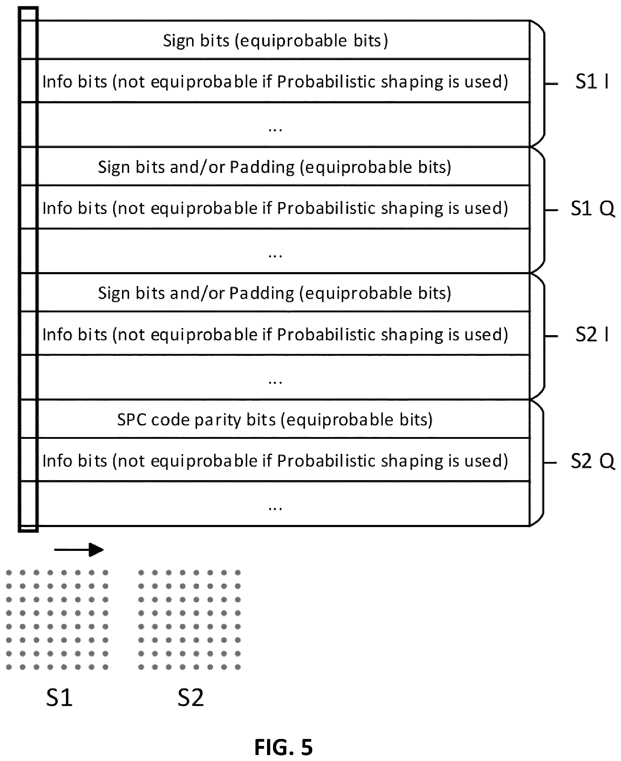

An embodiment may utilize a specific transmitter architecture where a bit-stream of input information, denoted as X, is demultiplexed into two distinct data streams: X1, X2, as illustrated in Fig. 2. X1 may be referred to as padding data, and the partitioning between X1 and X2 is dependent on a modulation format and an FEC code rate, as discussed in the context of interleaver design. In cases where probabilistic shaping is required, X2 may be subjected to optional pulse amplitude shaping, employing DM (distribution matcher) and Sym2bit (symbol-to-bit) blocks. The DM takes a sequence of uniformly distributed input bits and maps them to a non-uniformly distributed output sequence. The output sequence symbols are selected based on a predetermined probability distribution. Symbols that are more likely to occur are transmitted more often, while less likely symbols are transmitted less frequently. For achieving this non-uniform mapping, the DM employs specific algorithms, including but not limited to constant composition distribution matching (CCDM), enumerative sphere shaping (ESS), hierarchical distribution matching (HiDM), and sequence selection (SS). These algorithms ensure that the output symbol sequence follows the desired probability distribution. The DM is then followed by bit labeling (Sym2bit). The DM may operate in conjunction with a specific bit labeling arrangement that assigns bits to the symbols in the constellation. This labeling, combined with the distribution shaping, ensures that the right symbols are chosen to minimize the energy and maximize the efficiency of the transmission. Further manipulation of X2 data involves additional demultiplexing, followed by independent encoding by N number of identical LDPC encoders. Serialization of the parity bits from the encoders is performed and integrated with the X1 data, then subjected to encoding with an SPC(n-1, n, 2) encoder. Serialization of the information bits from the encoders is followed by combination with the SPC encoders' output, allocated for sign bits. An interleaving process is then executed by a specially designed interleaver (as shown in Fig. 5), followed by Gray mapping to multiple consecutive QAM symbols, the number of which is dependent on the SPC code rate.

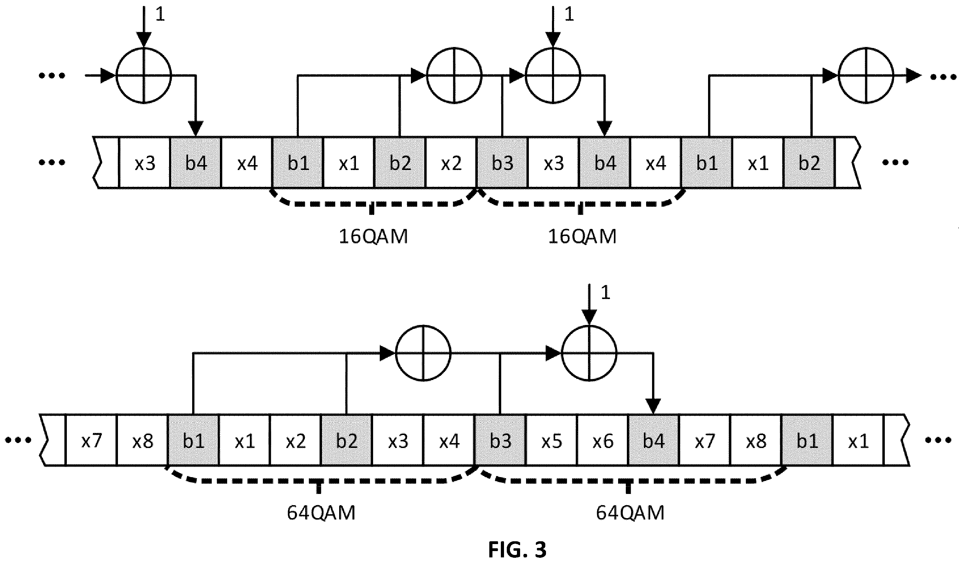

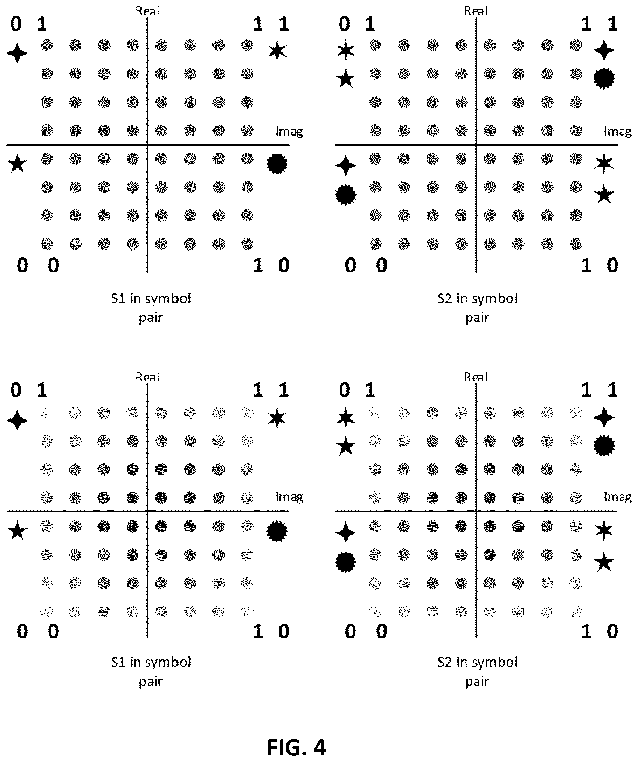

An embodiment may utilize any square QAM modulation format. A characteristic of square QAM symbols is that they are represented by an even number of bits. An analysis of the 16-QAM constellation, as depicted in Figure 3, reveals a consistency in the 1st and 3rd bits for each quadrant when employing Gray mapping. This may further be generalized to a 2^{2m}-QAM constellation where m is an integer, leading to the conclusion that the 1st and (m+1)th bits remain constant across each quadrant. For example, considering 64-QAM, with m = 3, it is found that the 1st and 4th bits are invariant for each quadrant. These specific bits may be utilized in the SPC coding. In Figures 4 to 7A-7D, SPC(3,4) are specifically used in combination with 64-QAM, to provide illustrative examples. Given that the output length of SPC is 4 bits, this translates to 2 symbols in temporal dimensionality (S1 and S2). Two bits are used for the I and Q components of S1, with the remaining 2 allocated for S2, thus rendering the modulation 4-dimensional. In contrast, the selection of SPC(a,8) where a is an integer, and a < 8, yields an 8-bit output, corresponding to 4 symbols in time (S1, S2, S3 and S4), thereby creating an 8-dimensional modulation scheme. As depicted in Figure 3, the "b" bits (b1, b2, b3, b4) symbolize the sign bits, while the "x" bits (x1 to x8) denote the information bits. Within the specific example of SPC(3,4), the relationship b4 = b1 ⊕ b2 ⊕ b3 ⊕ 1 is established. Consequently, the SPC(3,4) coded modulation involves taking 2 symbols simultaneously, calculating b4, and then proceeding to the subsequent symbol pair in a repetitive manner. Table 2 lists valid combinations of sign bits.

**Table 2. SPC(3,4), b4 = b1 ⊕ b2 ⊕ b3 ⊕ 1**

| Valid 4D symbol | S1 I | S1 Q | S2 I | S2 Q |
|---|---|---|---|---|
| | b1 | b2 | b3 | b4 |
| No | 0 | 0 | 0 | 0 |
| Yes | 0 | 0 | 0 | 1 |
| Yes | 0 | 0 | 1 | 0 |
| No | 0 | 0 | 1 | 1 |
| Yes | 0 | 1 | 0 | 0 |
| No | 0 | 1 | 0 | 1 |
| No | 0 | 1 | 1 | 0 |
| Yes | 0 | 1 | 1 | 1 |
| Yes | 1 | 0 | 0 | 0 |
| No | 1 | 0 | 0 | 1 |
| No | 1 | 0 | 1 | 0 |
| Yes | 1 | 0 | 1 | 1 |
| No | 1 | 1 | 0 | 0 |
| Yes | 1 | 1 | 0 | 1 |
| Yes | 1 | 1 | 1 | 0 |
| No | 1 | 1 | 1 | 1 |

Figure 4 illustrates how the SPC code may be implemented with 4D-64-QAM, as well as 4D-PS-64-QAM. In Figure 4, the symbols (4-point stars, 5-point stars, 6-point stars, and 16-point stars) on the constellation indicate the permissible symbol combinations. For instance, a 4-point star symbol within a quadrant on the first symbol mandates that only quadrants with 4-point stars are valid for the second symbol and so on and so forth. This star-coded arrangement helps with understanding the allowed symbol pairings within the modulation scheme and the modulation process in higher-dimensional spaces.

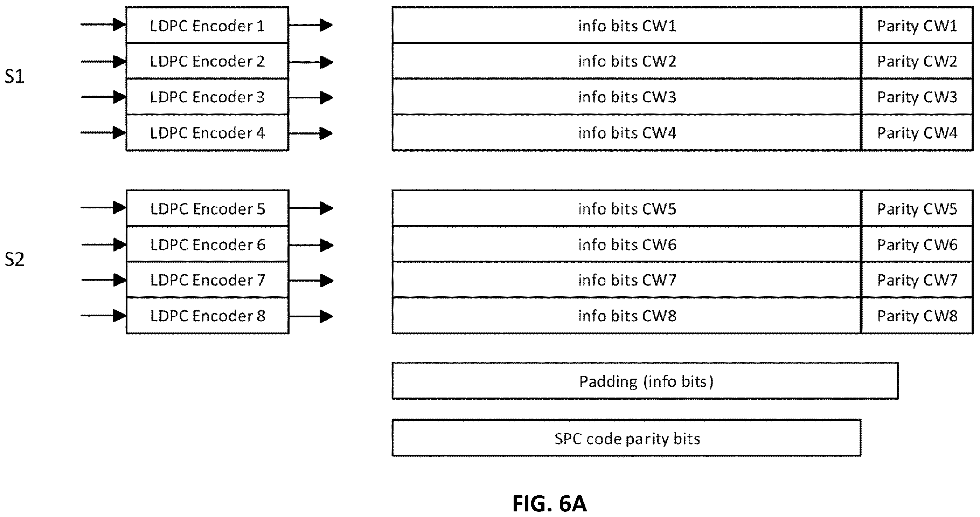

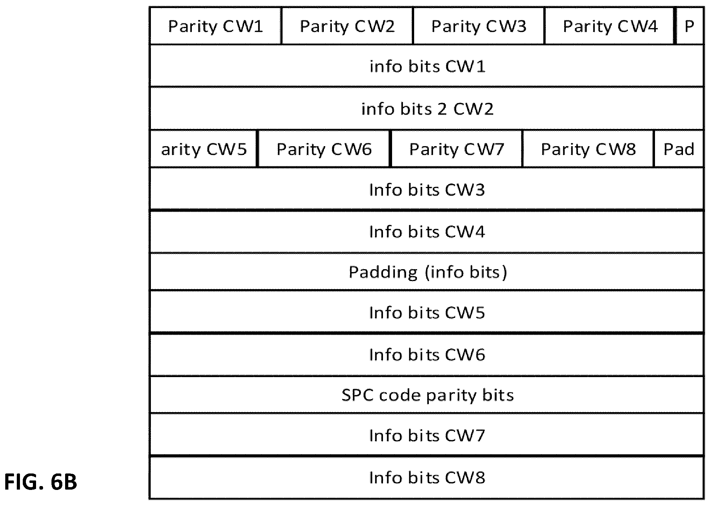

In an embodiment, in the interleaver operation, data is processed through a specific orientation whereby the data is written in a row-wise manner and read in a column-wise manner. Given that the location of sign bits is known, their extraction and proper placement may be easily achieved. For example, in the specific case of an SPC(3,4) configuration combined with 64QAM modulation, the sign bits are allocated to certain rows within the interleaver matrix. For example, the 1st and 4th, as well as the 7th and 10th rows may be reserved for the sign bits, while information bits occupy the remaining rows. Within the context of the SPC(3,4) example, the 10th row symbolizes the b4 bits, formally represented by an equation: 10th row = 1st row ⊕ 4th row ⊕ 7th row ⊕ 1. The number of sign bits may be determined by the number of the information bits entering the LDPC encoders and the specific LDPC code rate. Hence, there is no guarantee that the number of sign bits and the information bits are compatible. Therefore, a first bit stream X1 is provided, whose ratio with a second bit stream X2 may be determined by the modulation format, SPC code rate, and LDPC code rate, as mentioned above in the transmitter description. Any shortage in sign bits derived from the parity of LDPC codes may be supplemented by X1 which serve as padding bits. The padding bits do not mean an absence of actual data; the term merely refers to the completion of the set of the sign bits. See also Figure 5. This implementation scheme may impose certain limitations on the range of LDPC code rates, which may be dependent on the SPC code rate and the modulation formats employed. Table 3 lists minimum allowable LDPC code rates that may be applied, based on the input parameters. Figure 6A and 6B further illustrates how the codewords and padding bits are integrated into the interleaver. While the sign bits remain unscrambled, the information bits are scrambled. This is depicted in the Figure 6A and 6B.

**Table 3. Minimum suitable LDPC code rates**

| **SPC code** | **16QAM** | **64QAM** | **256QAM** |
|---|---|---|---|
| **SPC(Sₖ,Sₙ)** | *k*/*n* ≥ Sₙ/(Sₖ+Sₙ) | *k*/*n* ≥ 2Sₙ/(Sₖ+2Sₙ) | *k*/*n* ≥ 3Sₙ/(Sₖ+3Sₙ) |
| **SPC(7,8)** | *k*/*n* ≥ 0.53 | *k*/*n* ≥ 0.70 | *k*/*n* ≥ 0.77 |
| **SPC(3,4)** | *k*/*n* ≥ 0.57 | *k*/*n* ≥ 0.73 | *k*/*n* ≥ 0.80 |
| **SPC(5,8)** | *k*/*n* ≥ 0.62 | *k*/*n* ≥ 0.76 | *k*/*n* ≥ 0.83 |
| **SPC(1,2)** | *k*/*n* ≥ 0.67 | *k*/*n* ≥ 0.80 | *k*/*n* ≥ 0.86 |

According to an embodiment, the interleaver enables multidimensional coding for probabilistic shaping. The interleaver may be able to employ a strategic reordering of incoming data, organizing the data in rows upon entry and then retrieving the data column-wise. This is particularly effective for precise management and extraction of sign bits which are crucial for the encoding process. Interleaver dimensionality, or the size of an interleaver matrix, may be defined to accommodate specific requirements of the encoding and modulation techniques employed. It may be determined by the dimensions Lₖ columns by Sₙ /2 x log₂(M) rows, where:
- Lₖ is the number of information bits input into an LDPC (Lₖ, Lₙ) code,
- Sₙ is the number of encoded bits output of an SPC (Sₖ, Sₙ) code,
- M is the constellation size of the modulation (e.g. 64 for 64-QAM), with log₂(M) calculating the bits required to represent each symbol.

In an embodiment, padding may refer to data used directly from the input stream without manipulation, and padding may be used to ensure the required structure of sign bits is complete, as dictated by the SPC code. The LDPC code enables to determine the number of sign bits, based on the specific LDPC code rate. The relationship between LDPC codes, SPC configurations, and modulation formats the minimum allowable LDPC code rates that may be applied in the proposed design, as shown in Table 3.

Figures 6A and 6B illustrates exemplary integration of codewords and padding bits within the interleaver, visually depicting how sign bits remain unscrambled, while the informational bits are scrambled, showcasing the strategic data organization. Figures 6A and 6B provides an exemplary illustration of the interleaver operation. The SPC code, not only specifies the arrangement of sign bits but may also introduce temporal dimensionality to their allocation. Sₙ enables to determine the number of temporal sequences or groupings for which the interleaver is to account, affecting how sign bits are distributed across these sequences within the interleaver matrix. The modulation size, denoted as M in terms of the constellation size, may directly influence the number of bits required to represent each symbol in the modulation scheme. This, in turn, enables to determine the number of potential positions for sign bits within each symbol. For instance:
- In 16-QAM where each symbol is represented by 4 bits, the positions for sign bits are typically the 1st and 3rd bits.
- In 64-QAM which uses 6 bits per symbol, the 1st and 4th bits are designated as sign bits.
- In 256-QAM, with 8 bits per symbol, the 1st and 5th bits serve as the sign bits.
- For a 64-QAM modulation with SPC(3,4) code, the interleaver matrix may accommodate 12 rows (6 bits per symbol x (4/2) for temporal symbols), with sign bits allocated at specific intervals reflecting both the modulation's sign bit positions and the SPC code's temporal sequences.
- With 256-QAM and SPC(5,6), the total rows increase to 24 (8 bits per symbol x 3 for temporal symbols), with the allocation pattern adjusted to place sign bits at the 1st and 5th positions for each of the three symbols represented resulting in the allocation of sign bits to the 1st, 5th, 9th, 13th, 17th, and 21st rows.

In an embodiment, in the receiver (see Fig. 2), demodulated data may be processed by a soft-input/soft-output maximum a posteriori (SISO-MAP) decoder, or multidimensional soft demapper. Bit log-likelihood ratios (LLRs) may be calculated and forwarded to an N number of identical low-density parity-check (LDPC) decoders. A MAP algorithm may be used for the sign bit LLRs, based on an optimum Wagner decoding algorithm for the SPC (n-1, n, 2) class, while the remaining bit LLRs may be determined using Euclidean distances of regular 2-dimensional QAM symbols. Extrinsic information from the LDPC decoders may be re-interleaved and sent back to the MAP decoders for use as a priori information in a next iteration as illustrated in Figure 2. At the end of the iterative process, the data may be divided into two parts, as shown in Figure 2. Bits representing sign bits and padding bits may be sent directly to the output, while the rest go through an inverse distribution matcher IDM, reversing the effect of the distribution matcher DM. The data is then combined at the output as the recovered received data stream X'.

In an embodiment, soft-input/soft-output decoding may be performed in the receiver, wherein upon reception, demodulated data may be processed by a soft-input/soft-output maximum a posteriori (SISO-MAP) decoder or a multidimensional soft demapper. Demapping may be used for calculating the bit log-likelihood ratios (LLRs), which serve as a measure of the probability that a received bit is a '0' or '1'. These LLRs may be then forwarded to N identical low-density parity-check (LDPC) decoders, initiating an error correction process.

In an embodiment, a MAP algorithm and sign bit LLRs may be used in the receiver. The SISO-MAP decoder or a multidimensional soft demapper may be employed for calculating the sign bit LLRs. This algorithm may be based on an optimum Wagner decoding principle tailored for the SPC (n-1, n, 2) class, ensuring that the sign bits are decoded with maximum reliability. For the remaining bit LLRs, Euclidean distances of the regular 2-dimensional QAM symbols are used, providing a robust method for determining the likelihood of bit values based on their proximity in the signal constellation.

In an embodiment, iterative decoding and information feedback may be applied in the receiver. In the iterative decoding process, extrinsic information may be extracted from the LDPC decoders is re-interleaved and fed back to the MAP decoders. This extrinsic information may be utilized as a priori information in subsequent iterations, enhancing the accuracy of the decoding process. This iterative loop significantly improves the error correction capabilities of the receiver, leading to higher data recovery accuracy.

In an embodiment, data demultiplexing and inverse distribution matching may be performed by the receiver, wherein after the iterative process, the data is demultiplexed, as depicted in Fig. 2. Bits identified as sign bits and padding may be routed directly to the output, bypassing further processing. In contrast, the remaining bits may be subjected to the inverse distribution matcher (IDM), effectively reversing the probabilistic shaping effects introduced during transmission. This step enables to ensure that the original data distribution is restored, preparing the data for final output combination. In output combination and data recovery, the data streams, now processed and corrected, may be combined at the output, concluding in the recovery of the transmitted data.

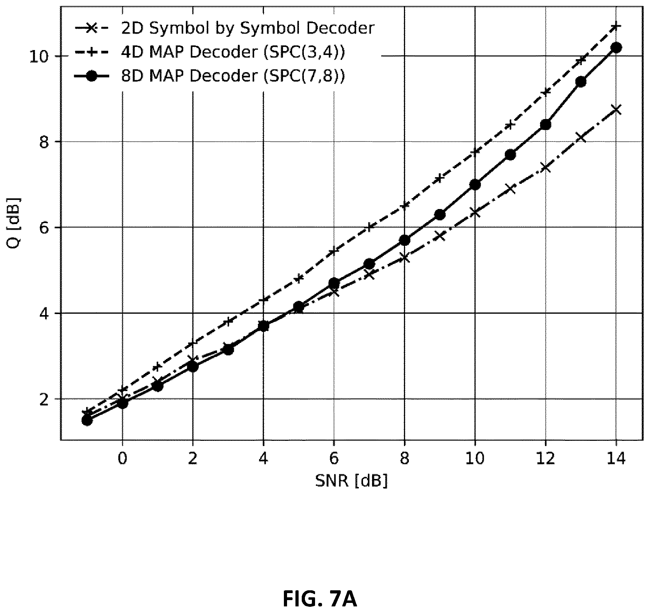

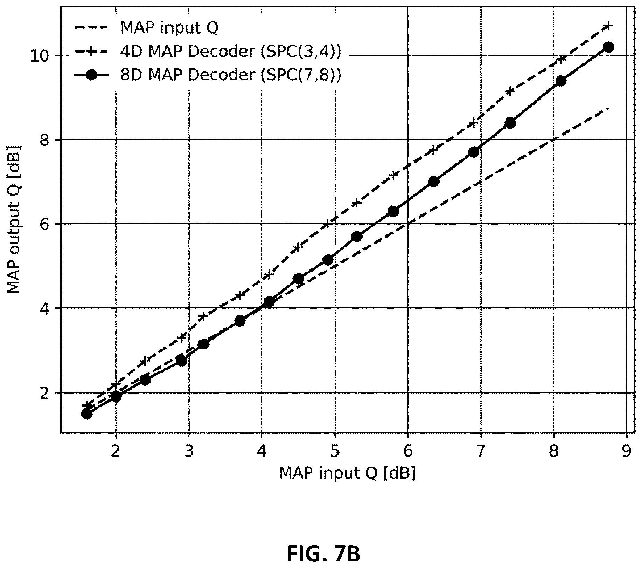

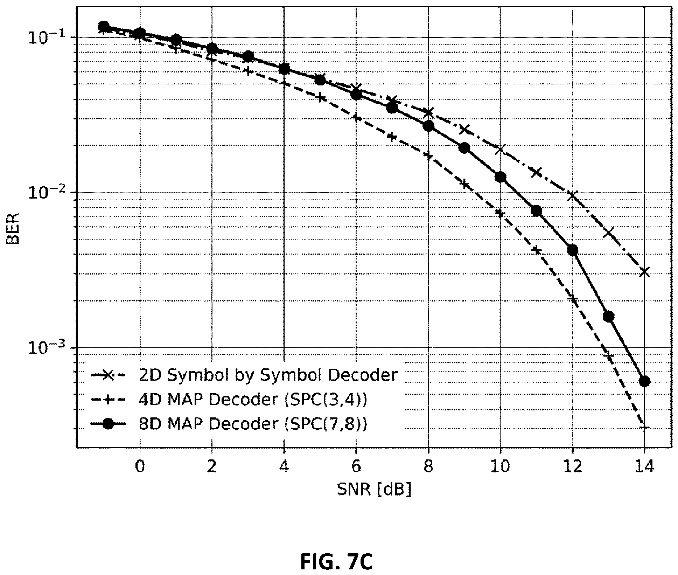

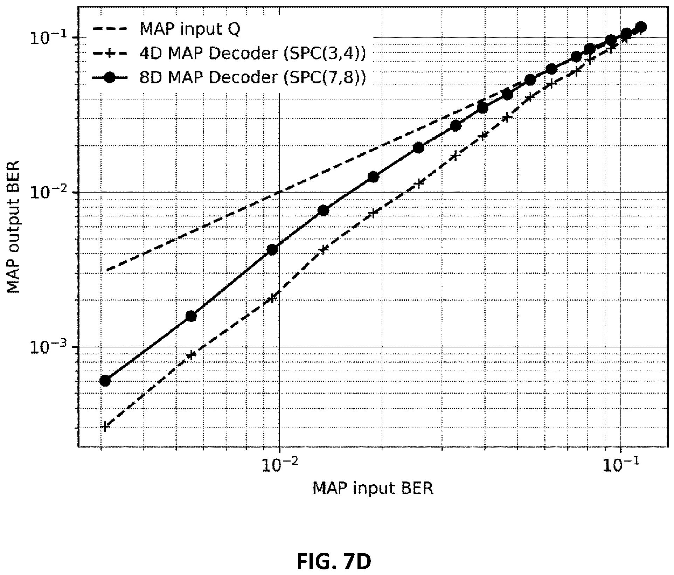

Figures 7A to 7D shows performance results of using multidimensional coding with SISO-MAP decoder. The results show that when using SPC codes, Q-factor improvement increases with SNR, which makes the current invention suitable for high SNR - high throughput channels for 6G. The benefit approaches 2dBQ at SNRs around 14 dB (1.5 dB SNR at a bit error rate (BER) of 2e-3). Additionally, Figures 7A to 7D enable to detect the differential performance of various SPC codes. Notably, a decrease in overhead corresponds to an expansion in dimensionality, and a reduction in improvement compared to the 2D scenario. This finding may be particularly significant for maintaining constraints on hardware complexity and latency, confirming that there is no need to extend beyond 4-dimensional modulation, or 2 symbols in time.

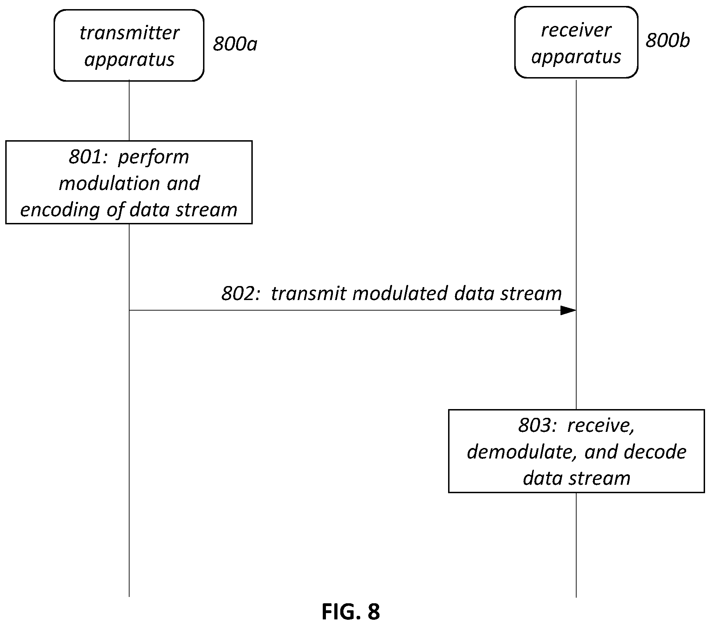

FIG. 8 illustrates a signal flow diagram according to an example embodiment.

Referring to FIG. 8, at 801, an apparatus 9800 which may be referred to as a transmitter apparatus 800a which may be, comprise, or be comprised in a network device, such as a terminal device 100, 102, a radio access network node 104, 104B, 104C or a distributed unit 105, 105B or a central unit 108, 108B, an access and mobility management function 111 of a core network 110, or network function virtualization infrastructure, is configured to receive an input data stream, and partition the input data stream to obtain a first bit stream X1 and a second bit stream X2. Further at 801, the transmitter apparatus is configured to subject the second bit stream X2 to manipulation at least by encoding by an N number of identical low-density parity check, LDPC, encoders, to obtain X2 parity bits, and X2 information bits. The transmitter apparatus applies single parity check, SPC, encoding to the X2 parity bits, together with the first bit stream X1, to obtain sign bits, wherein the first bit stream X1 is used as padding bits. The sign bits, the padding bits, and the X2 information bits, are subjected by the transmitter apparatus to an interleaver operation, wherein in the interleaver operation the sign bits, the padding bits, and the X2 information bits are written sequentially in a row-wise orientation into an interleaver matrix, and then read sequentially in a column-wise manner from the interleaver matrix to obtain an interleaver output. The transmitter apparatus is further configured to subject the interleaver output to Gray mapping to form multiple consecutive quadratic amplitude modulation, QAM, symbols, and modulate the QAM symbols by quadratic amplitude modulation to obtain a modulated data stream.

Further referring to FIG. 8, a serialization of the X2 parity bits obtained from the LDPC encoders may be performed by the transmitter apparatus in a parallel-to-serial, P/S, converter, before the X2 parity bits are integrated with the first bit stream X1. The transmitter apparatus may be caused to subject the second bit stream X2 to probabilistic amplitude shaping (PAS) by distribution matching followed by bit labelling, and thereafter to a serialization in a parallel-to-serial (P/S) converter, before the manipulation of the second bit stream X2 by the LDPC encoders. The distribution matching may be carried out using an algorithm selected from one or more of: constant composition distribution matching, CCDM, enumerative sphere shaping, ESS, hierarchical distribution matching, HiDM, or sequence selection, SS. The bit labelling may comprise symbol-to-bit (Sym2bit) bit labelling. The transmitter apparatus may be caused to apply a 2^{2m}-QAM constellation where m is an integer, wherein the first and (m+1)^{th} bits remain constant across each quadrant. The sign bits may be allocated to selected rows within the interleaver matrix. The number of sign bits may be determined by a number of the X2 information bits entering the LDPC encoders and LDPC code rate, A size ratio between the first bit stream X1 and the second bit stream X2 may be determined based on which QAM modulation format, SPC code rate and LDPC code rate are being used. The padding bits may be used to supplement the sign bits in the interleaver matrix. The transmitter apparatus may be caused to subject the second bit stream X2 to a serial-to-parallel (S/P) converter, after the Sym2bit bit labelling and before the manipulation of the second bit stream X2 by the LDPC encoders.

At 802, the transmitter apparatus is configured to transmit the modulated data stream via a radio access network or optical fibre communication network to an another apparatus 9800 which may be referred to as a receiver apparatus 800b which may be, comprise, or be comprised in another network device, such as a terminal device 100, 102, a radio access network node 104, 104B, 104C or a distributed unit 105, 105B or a central unit 108, 108B, an access and mobility management function 111 of a core network 110, or network function virtualization infrastructure.

At 803, the receiver apparatus is configured to receive the modulated data stream via the radio access network or optical fibre communication network from the transmitter apparatus. Further at 803, the receiver apparatus is configured to demodulate the data stream received by the apparatus via the radio access network or optical fibre communication network, to obtain a demodulated data stream. The receiver apparatus demaps the demodulated data stream by a soft-input/soft-output maximum a posteriori (SISO-MAP) decoder, or by a multidimensional soft demapper, to obtain a demapped data stream and bit log-likelihood ratios (LLRs). The receiver apparatus subjects the demapped data stream to a deinterleaver operation, wherein in the deinterleaver operation bits of the demapped data stream are written sequentially in a column-wise orientation into a deinterleaver matrix, and then the bits are read sequentially in a row-wise manner from the deinterleaver matrix to obtain a deinterleaver output. The receiver apparatus subjects the deinterleaver output to a forward error correction (FEC) process by feeding the deinterleaver output and the bit log-likelihood ratios (LLRs) to an N number of identical low-density parity check (LDPC) decoders.

The receiver apparatus may further be caused to perform an iterative decoding process, wherein extrinsic information extracted from the LDPC decoders in the FEC process, is re-interleaved by an interleaver operation, and then fed back to the SISO-MAP decoder or demapper for demapping. The received data stream may be demodulated by quadratic amplitude demodulation. The receiver apparatus may be caused to perform data multiplexing after the iterative decoding process, route bits identified as sign bits and bits identified as padding bits directly from the data multiplexing towards an output without subjecting them to reverse probabilistic shaping, subject remaining bits which include the X2' information bits, to the reverse probabilistic shaping in an inverse distribution matcher, IDM, to reverse probabilistic shaping effects introduced during transmission of the data stream, and obtain a final restored output data stream X' by combining the bits identified as the sign bits and as the padding bits with the X2' information bits subjected to the reverse probabilistic shaping.

The LLR may indicate a probability whether a value of a received bit is 0 or 1. The receiver apparatus may be caused to utilize the extrinsic information as a priori information in the SISO-MAP decoder or demapper, to enhance the accuracy of the iterative decoding process. The receiver apparatus may be caused to utilize the SISO-MAP decoder or demapper to calculate sign bit LLRs, by using an algorithm based on an optimum Wagner decoding principle tailored for single parity check (SPC) encoding, wherein for remaining bit LLRs, Euclidean distances of regular 2-dimensional QAM symbols are used, to determine a likelihood of bit values based on their proximity in a signal constellation.

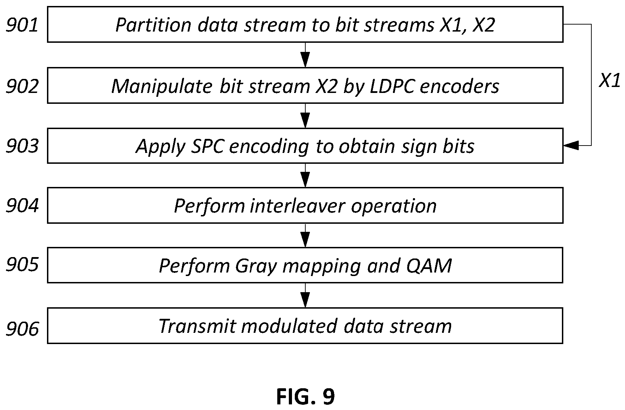

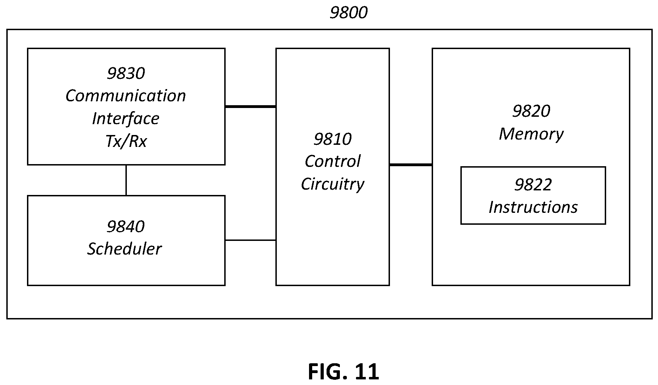

FIG. 9 illustrates a flow chart according to an example embodiment of a method performed by an apparatus 9800 depicted in FIG. 11. For example, the apparatus 9800 which may be referred to as a transmitter apparatus 800a, may be, or comprise, or be comprised in, a terminal device 100, 102, a radio access network node 104, 104B, 104C or a distributed unit 105, 105B or a central unit 108, 108B, an access and mobility management function 111 of a core network 110, or network function virtualization infrastructure.

Referring to FIG. 9, in block 901, the transmitter apparatus is configured to obtain an input data stream, and partition the input data stream to obtain a first bit stream X1 and a second bit stream X2. In block 902, the transmitter apparatus is configured to subject the second bit stream X2 to manipulation at least by encoding by an N number of identical low-density parity check (LDPC) encoders, to obtain X2 parity bits, and X2 information bits. In block 903, the transmitter apparatus applies single parity check, SPC, encoding to the X2 parity bits, together with the first bit stream X1, to obtain sign bits, wherein the first bit stream X1 is used as padding bits. In block 904, the sign bits, the padding bits, and the X2 information bits, are subjected by the transmitter apparatus to an interleaver operation, wherein in the interleaver operation the sign bits, the padding bits, and the X2 information bits are written sequentially in a row-wise orientation into an interleaver matrix, and then read sequentially in a column-wise manner from the interleaver matrix to obtain an interleaver output. The application of the LDPC encoding and SPC encoding, etc., are further illustrated in Fig. 2. In block 905, the transmitter apparatus is further configured to subject the interleaver output to Gray mapping to form multiple consecutive quadratic amplitude modulation (QAM) symbols, and modulate the QAM symbols by quadratic amplitude modulation to obtain a modulated data stream. Exemplary interleaver operation, Gray mapping and QAM modulation are further illustrated in Figures 3 to 6A-6B.

As shown in Fig. 2, a serialization of the X2 parity bits obtained from the LDPC encoders may be performed by the transmitter apparatus in a parallel-to-serial (P/S) converter, before the X2 parity bits are integrated with the first bit stream X1. As shown in Fig. 2, the transmitter apparatus may be caused to subject the second bit stream X2 to probabilistic amplitude shaping (PAS) by distribution matching followed by bit labelling, and thereafter to a serialization in a parallel-to-serial, P/S, converter, before the manipulation of the second bit stream X2 by the LDPC encoders. The distribution matching (DM) may be carried out using an algorithm selected from one or more of: constant composition distribution matching (CCDM), enumerative sphere shaping (ESS), hierarchical distribution matching (HiDM), or sequence selection (SS). The bit labelling may comprise symbol-to-bit, Sym2bit, bit labelling, as shown in Fig. 2.

The transmitter apparatus may be caused to apply a 2^{2m}-QAM constellation where m is an integer, wherein the first and (m+1)^{th} bits remain constant across each quadrant; see block 905, and Fig. 3. The sign bits may be allocated to selected rows within the interleaver matrix; see block 904, and Fig. 5, 6A, 6B. The number of sign bits may be determined by a number of the X2 information bits entering the LDPC encoders and LDPC code rate. A size ratio between the first bit stream X1 and the second bit stream X2 may be determined based on which QAM modulation format, SPC code rate and LDPC code rate are being used. The padding bits may be used to supplement the sign bits in the interleaver matrix; see Fig. 6A-6B as an example.

In block 906, the transmitter apparatus is configured to transmit the modulated data stream via a radio access network or optical fibre communication network to an another apparatus which may be referred to as a receiver apparatus which may be, comprise, or be comprised in another network device, such as a terminal device 100, 102, a radio access network node 104, 104B, 104C or a distributed unit 105, 105B or a central unit 108, 108B, an access and mobility management function 111 of a core network 110, or network function virtualization infrastructure.

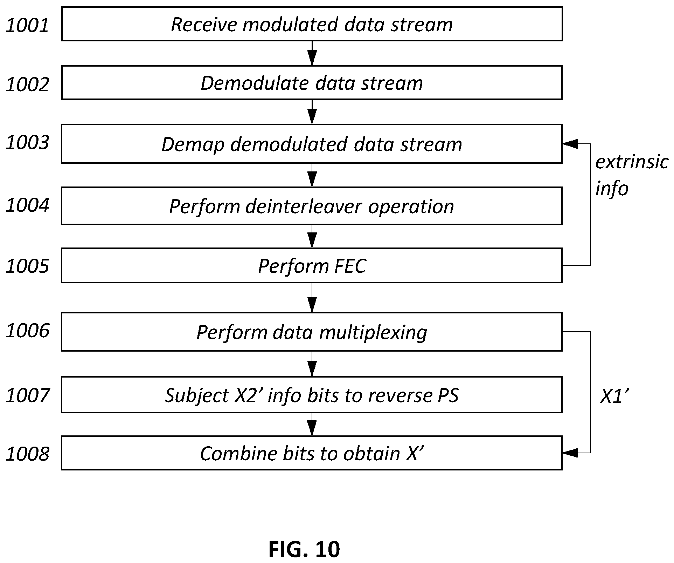

FIG. 10 illustrates a flow chart according to an example embodiment of a method performed by an apparatus 9800 depicted in FIG. 11. For example, the apparatus 9800 which may be referred to as a receiver apparatus 800b may be, or comprise, or be comprised in, a terminal device 100, 102, a radio access network node 104, 104B, 104C or a distributed unit 105, 105B or a central unit 108, 108B, an access and mobility management function 111 of a core network 110, or network function virtualization infrastructure.

Referring to FIG. 10, in block 1001, the receiver apparatus is configured to receive the modulated data stream via the radio access network or optical fibre communication network from the transmitter apparatus. In block 1002, the receiver apparatus is configured to demodulate the data stream received by the receiver apparatus via the radio access network or optical fibre communication network, to obtain a demodulated data stream. The received data stream may be demodulated by the receiver apparatus by quadratic amplitude demodulation in block 1002. In block 1003, the receiver apparatus demaps the demodulated data stream by a soft-input/soft-output maximum a posteriori, SISO-MAP, decoder, or by a multidimensional soft demapper, to obtain bit log-likelihood ratios (LLRs). In block 1004, the receiver apparatus subjects the demapped data stream to a deinterleaver operation, wherein in the deinterleaver operation bits of the demapped data stream are written sequentially in a column-wise orientation into a deinterleaver matrix, and then the bits are read sequentially in a row-wise manner from the deinterleaver matrix to obtain a deinterleaver output. In block 1005, the receiver apparatus subjects the deinterleaver output to a forward error correction (FEC) process by feeding the deinterleaver output and the bit log-likelihood ratios (LLRs), to an N number of identical low-density parity check (LDPC) decoders.

The receiver apparatus may further be caused to perform an iterative decoding process, wherein extrinsic information extracted from the LDPC decoders in the FEC process, is re-interleaved by an interleaver operation, and then fed back to the SISO-MAP decoder or demapper to recalculate the LLRs; see Fig. 2 and 10. In block 1006, the receiver apparatus may be caused to perform data multiplexing after the iterative decoding process, and route bits identified as sign bits and bits identified as padding bits directly from the data multiplexing towards an output without subjecting them to reverse probabilistic shaping. In block 1007, the receiver apparatus may be caused to subject remaining bits which include the X2' information bits, to the reverse probabilistic shaping in an inverse distribution matcher, IDM, to reverse probabilistic shaping effects introduced during transmission of the data stream. In block 1008, the receiver apparatus may be caused to obtain a final restored output data stream X' by combining the bits identified as the sign bits and as the padding bits with the X2' information bits subjected to the reverse probabilistic shaping.

The log-likelihood ratio (LLR) may indicate a probability whether a value of a received bit is 0 or 1. The receiver apparatus may be caused to utilize the extrinsic information as a priori information in the SISO-MAP decoder or demapper, to enhance the accuracy of the iterative decoding process, as shown in Fig. 2 and 10. The receiver apparatus may be caused to utilize the SISO-MAP decoder or demapper to calculate sign bit LLRs, by using an algorithm based on an optimum Wagner decoding principle tailored for single parity check, SPC, encoding, wherein for remaining bit LLRs, Euclidean distances of regular 2-dimensional QAM symbols are used, to determine a likelihood of bit values based on their proximity in a signal constellation; see block 1003.

The blocks, related functions, and information exchanges (messages) described above by means of FIGS. 2-10 are in no absolute chronological order, and some of them may be performed simultaneously or in an order differing from the described one. Other functions can also be executed between them or within them, and other information may be sent, and/or other rules applied. Some of the blocks or part of the blocks or one or more pieces of information can also be left out or replaced by a corresponding block or part of the block or one or more pieces of information.

As used herein, "at least one of the following: <a list of two or more elements>" and "at least one of <a list of two or more elements>" and similar wording, where the list of two or more elements are joined by "and" or "or", mean at least any one of the elements, or at least any two or more of the elements, or at least all the elements.

An embodiment enables to improve spectral efficiency at high signal-to-noise ratios. Probabilistic shaping for 6G using short LDPC codes is enabled, as well as the provision of continuous data rate adaptation (fine steps in SE) based on channel quality. A flexible transmitter/receiver design is provided that is adaptable to any modulation format. Added redundancy does not drastically reduce spectral efficiency (SE). The outer code improves the de-mapping process and improves the quality of the log-likelihood ratios (LLRs) at the receiver, to potentially reduce the overall number of iterations and/or reduce the block-error-rate (BLER). The symbol error ratio at the input of LDPC decoders may also be improved.

FIG. 11 illustrates an example of an apparatus 9800 comprising means for performing one or more of the example embodiments described above. For example, the apparatus 9800 may be, or comprise, or be comprised in, a terminal device 100, 102, a radio access network node 104, 104B, 104C or a distributed unit 105, 105B or a central unit 108, 108B, or an access and mobility management function 111 of a core network 110, or the means may be network function virtualization infrastructure. The apparatus 9800 may be, or comprise, or be comprised in the transmitter apparatus 800a and/or receiver apparatus 800b.

The apparatus 9800 may comprise, for example, a circuitry or a chipset applicable for realizing one or more of the example embodiments described above. The apparatus 9800 may be an electronic device comprising one or more electronic circuitries. The apparatus 9800 may comprise a communication control circuitry 9810 such as at least one processor, and at least one memory 9820 storing instructions 9822 which, when executed by the at least one processor, cause the apparatus 9800 to carry out one or more of the example embodiments described above. Such instructions 9822 may, for example, include computer program code (software). The at least one processor and the at least one memory storing the instructions may provide the means for providing or causing the performance of any of the methods and/or blocks described above.

The processor is coupled to the memory 9820. The processor is configured to read and write data to and from the memory 9820. The memory 9820 may comprise one or more memory units. The memory units may be volatile or non-volatile. It is to be noted that there may be one or more units of non-volatile memory and one or more units of volatile memory or, alternatively, one or more units of non-volatile memory, or, alternatively, one or more units of volatile memory. Volatile memory may be for example random-access memory (RAM), dynamic random-access memory (DRAM) or synchronous dynamic random-access memory (SDRAM). Non-volatile memory may be for example read-only memory (ROM), programmable read-only memory (PROM), electronically erasable programmable read-only memory (EEPROM), flash memory, optical storage or magnetic storage. In general, memories may be referred to as non-transitory computer readable media. The term "non-transitory," as used herein, is a limitation of the medium itself (i.e., tangible, not a signal) as opposed to a limitation on data storage persistency (e.g., RAM vs. ROM). The memory 9820 stores computer readable instructions that are executed by the processor. For example, non-volatile memory stores the computer readable instructions, and the processor executes the instructions using volatile memory for temporary storage of data and/or instructions.

The computer readable instructions may have been pre-stored to the memory 9820 or, alternatively or additionally, they may be received, by the apparatus, via an electromagnetic carrier signal and/or may be copied from a physical entity such as a computer program product. Execution of the computer readable instructions causes the apparatus 9800 to perform one or more of the functionalities described above.

The memory 9820 may be implemented using any suitable data storage technology, such as semiconductor-based memory devices, flash memory, magnetic memory devices and systems, optical memory devices and systems, fixed memory and/or removable memory. The memory may comprise a configuration database for storing configuration data, such as a current neighbour cell list, and, in some example embodiments, structures of frames used in the detected neighbour cells.

The apparatus 9800 may further comprise or be connected to a communication interface 9830, such as a radio unit, comprising hardware and/or software for realizing communication connectivity with one or more wireless communication devices according to one or more communication protocols. The communication interface 9830 comprises at least one transmitter (Tx) and at least one receiver (Rx) that may be integrated to the apparatus 9800 or that the apparatus 9800 may be connected to. The communication interface 9830 may provide means for performing some of the blocks for one or more example embodiments described above. The communication interface 9830 may comprise one or more components, such as: power amplifier, digital front end (DFE), analog-to-digital converter (ADC), digital-to-analog converter (DAC), frequency converter, (de)modulator, and/or encoder/decoder circuitries, controlled by the corresponding controlling units.

The communication interface 9830 provides the apparatus with radio communication capabilities to communicate in the wireless communication network. The communication interface may, for example, provide a radio interface to one or more UEs 100, 102. The apparatus 9800 may further comprise or be connected to another interface towards a core network 110, such as the network coordinator apparatus or AMF 111, and/or to the access nodes 104 of the wireless communication network. The communication interface 9830 may, for example, provide a radio, or fiber interface to one or more network nodes of a radio access network or core network.

The apparatus 9800 may further comprise a scheduler 9840 that is configured to allocate radio resources. The scheduler 9840 may be configured along with the communication control circuitry 9810 or it may be separately configured.

It is to be noted that the apparatus 9800 may further comprise various components not illustrated in FIG. 11. The various components may be hardware components and/or software components.

As used in this application, the term "circuitry" may refer to one or more or all of the following: a) hardware-only circuit implementations (such as implementations in only analog and/or digital circuitry); and b) combinations of hardware circuits and software, such as (as applicable): i) a combination of analog and/or digital hardware circuit(s) with software/firmware and ii) any portions of hardware processor(s) with software (including digital signal processor(s), software, and memory(ies) that work together to cause an apparatus, such as a mobile phone, to perform various functions); and c) hardware circuit(s) and/or processor(s), such as a microprocessor(s) or a portion of a microprocessor(s), that requires software (for example firmware) for operation, but the software may not be present when it is not needed for operation.

This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, a baseband integrated circuit or processor integrated circuit for a mobile device or a similar integrated circuit in server, a cellular network device, or other computing or network device.

The techniques and methods described herein may be implemented by various means. For example, these techniques may be implemented in hardware (one or more devices), firmware (one or more devices), software (one or more modules), or combinations thereof. For a hardware implementation, the apparatus(es) of example embodiments may be implemented within one or more application-specific integrated circuits (ASICs), digital signal processors (DSPs), digital signal processing devices (DSPDs), programmable logic devices (PLDs), field programmable gate arrays (FPGAs), graphics processing units (GPUs), processors, controllers, micro-controllers, microprocessors, other electronic units designed to perform the functions described herein, or a combination thereof. For firmware or software, the implementation can be carried out through modules of at least one chipset (for example procedures, functions, and so on) that perform the functions described herein. The software codes may be stored in a memory unit and executed by processors. The memory unit may be implemented within the processor or externally to the processor. In the latter case, it can be communicatively coupled to the processor via various means, as is known in the art. Additionally, the components of the systems described herein may be rearranged and/or complemented by additional components in order to facilitate the achievements of the various aspects, etc., described with regard thereto, and they are not limited to the precise configurations set forth in the given figures, as will be appreciated by one skilled in the art.

It will be obvious to a person skilled in the art that, as technology advances, the inventive concept may be implemented in various ways within the scope of the claims. The embodiments are not limited to the example embodiments described above, but may vary within the scope of the claims. Therefore, all words and expressions should be interpreted broadly, and they are intended to illustrate, not to restrict, the embodiments.

## Claims

1. An apparatus comprising at least one processor, and at least one memory storing instructions that, when executed by the at least one processor, cause the apparatus at least to:
partition an input data stream to obtain a first bit stream X1 and a second bit stream X2;
subject the second bit stream X2 to manipulation at least by encoding by an N number of identical low-density parity check, LDPC, encoders, to obtain X2 parity bits, and X2 information bits;
apply single parity check, SPC, encoding to the X2 parity bits, together with the first bit stream X1, to obtain sign bits, wherein the first bit stream X1 is used as padding bits;
subject the sign bits, the padding bits, and the X2 information bits, to an interleaver operation, wherein in the interleaver operation the sign bits, the padding bits, and the X2 information bits are written sequentially in a row-wise orientation into an interleaver matrix, and then read sequentially in a column-wise manner from the interleaver matrix to obtain an interleaver output;
subject the interleaver output to Gray mapping to form multiple consecutive quadratic amplitude modulation, QAM, symbols;
modulate the QAM symbols by quadratic amplitude modulation to obtain a modulated data stream; and
transmit the modulated data stream via a radio access network or optical fibre communication network.

2. The apparatus according to claim 1, wherein a serialization of the X2 parity bits obtained from the low-density parity check, LDPC, encoders is performed in a parallel-to-serial, P/S, converter, before the X2 parity bits are integrated with the first bit stream X1.

3. The apparatus according to claim 1 or 2, further being caused to:
subject the second bit stream X2 to probabilistic amplitude shaping by distribution matching followed by bit labelling, and thereafter to a serialization in a parallel-to-serial converter, P/S,
before the manipulation of the second bit stream X2 by the low-density parity check, LDPC, encoders.

4. The apparatus according to claim 3,
wherein the distribution matching is carried out using an algorithm selected from one or more of: constant composition distribution matching, CCDM, enumerative sphere shaping, ESS, hierarchical distribution matching, HiDM, or sequence selection, SS; and/or
wherein the bit labelling comprises symbol-to-bit, Sym2bit, bit labelling.

5. The apparatus according to any preceding claim, being caused to:
apply a 2^{2m}-QAM constellation where m is an integer, wherein the first and (m+1)^{th} bits remain constant across each quadrant.

6. The apparatus according to any preceding claim, wherein
the sign bits are allocated to selected rows within the interleaver matrix,
the number of sign bits is determined by a number of the X2 information bits entering the low-density parity check, LDPC, encoders and LDPC code rate,
a size ratio between the first bit stream X1 and the second bit stream X2 is determined based on which QAM modulation format, SPC code rate and LDPC code rate are being used, and
the padding bits are used to supplement the sign bits in the interleaver matrix.

7. An apparatus comprising at least one processor, and at least one memory storing instructions that, when executed by the at least one processor, cause the apparatus at least to:
demodulate a data stream received by the apparatus via a radio access network or optical fibre communication network, to obtain a demodulated data stream;
demap the demodulated data stream by a soft-input/soft-output maximum a posteriori, SISO-MAP, decoder, or by a multidimensional soft demapper, to obtain a demapped data stream and bit log-likelihood ratios;
subject the demapped data stream to a deinterleaver operation, wherein in the deinterleaver operation bits of the demapped data stream are written sequentially in a column-wise orientation into a deinterleaver matrix, and then the bits are read sequentially in a row-wise manner from the deinterleaver matrix to obtain a deinterleaver output; and
subject the deinterleaver output to a forward error correction, FEC, process by feeding the deinterleaver output and the bit log-likelihood ratios to an N number of identical low-density parity check, LDPC, decoders.

8. The apparatus according to claim 7, further being caused to:
perform an iterative decoding process, wherein extrinsic information extracted from the low-density parity check, LDPC, decoders in the forward error correction, FEC, process, is re-interleaved by an interleaver operation, and then fed back to the SISO-MAP decoder or demapper for demapping.

9. The apparatus according to claim 7 or 8, further being caused to:
perform data multiplexing after the iterative decoding process;
route bits identified as sign bits and bits identified as padding bits directly from the data multiplexing towards an output without subjecting them to reverse probabilistic shaping;
subject remaining bits which include the X2' information bits, to the reverse probabilistic shaping in an inverse distribution matcher to reverse probabilistic shaping effects introduced during transmission of the data stream; and
obtain a final restored output data stream X' by combining the bits identified as the sign bits and as the padding bits with the X2' information bits subjected to the reverse probabilistic shaping.

10. The apparatus according to any preceding claim 7 to 9, being caused to:
utilize the extrinsic information as a priori information in the SISO-MAP decoder or demapper, to enhance the accuracy of the iterative decoding process; and/or
utilize the SISO-MAP decoder or demapper to calculate sign bit log-likelihood ratios, by using an algorithm based on an optimum Wagner decoding principle tailored for single parity check, SPC, encoding, wherein for remaining bit log-likelihood ratios, Euclidean distances of regular 2-dimensional QAM symbols are used, to determine a likelihood of bit values based on their proximity in a signal constellation.

11. The apparatus according to any preceding claim, wherein it is, comprises, or is comprised in, a terminal device, access node, or core network node.

12. A method comprising performing, by an apparatus:
partitioning an input data stream to obtain a first bit stream X1 and a second bit stream X2;
subjecting the second bit stream X2 to manipulation at least by encoding by an N number of identical low-density parity check, LDPC, encoders, to obtain X2 parity bits, and X2 information bits;
applying single parity check, SPC, encoding to the X2 parity bits, together with the first bit stream X1, to obtain sign bits, wherein the first bit stream X1 is used as padding bits;
subjecting the sign bits, the padding bits, and the X2 information bits, to an interleaver operation, wherein in the interleaver operation the sign bits, the padding bits, and the X2 information bits are written sequentially in a row-wise orientation into an interleaver matrix, and then read sequentially in a column-wise manner from the interleaver matrix to obtain an interleaver output;
subjecting the interleaver output to Gray mapping to form multiple consecutive quadratic amplitude modulation, QAM, symbols;
modulating the QAM symbols by quadratic amplitude modulation to obtain a modulated data stream; and
transmitting the modulated data stream via a radio access network or optical fibre communication network.

13. A method comprising performing, by an apparatus:
demodulating a data stream received by the apparatus via a radio access network or optical fibre communication network, to obtain a demodulated data stream;
demapping the demodulated data stream by a soft-input/soft-output maximum a posteriori, SISO-MAP, decoder, or by a multidimensional soft demapper, to obtain a demapped data stream and bit log-likelihood ratios;
subjecting the demapped data stream to a deinterleaver operation, wherein in the deinterleaver operation bits of the demapped data stream are written sequentially in a column-wise orientation into a deinterleaver matrix, and then the bits are read sequentially in a row-wise manner from the deinterleaver matrix to obtain a deinterleaver output; and
subjecting the deinterleaver output to a forward error correction, FEC, process by feeding the deinterleaver output and the bit log-likelihood ratios to an N number of identical low-density parity check, LDPC, decoders.

14. A non-transitory computer readable medium comprising program instructions which, when executed by an apparatus, cause the apparatus to perform at least the following:
partition an input data stream to obtain a first bit stream X1 and a second bit stream X2;
subject the second bit stream X2 to manipulation at least by encoding by an N number of identical low-density parity check, LDPC, encoders, to obtain X2 parity bits, and X2 information bits;
apply single parity check, SPC, encoding to the X2 parity bits, together with the first bit stream X1, to obtain sign bits, wherein the first bit stream X1 is used as padding bits;
subject the sign bits, the padding bits, and the X2 information bits, to an interleaver operation, wherein in the interleaver operation the sign bits, the padding bits, and the X2 information bits are written sequentially in a row-wise orientation into an interleaver matrix, and then read sequentially in a column-wise manner from the interleaver matrix to obtain an interleaver output;
subject the interleaver output to Gray mapping to form multiple consecutive quadratic amplitude modulation, QAM, symbols;
modulate the QAM symbols by quadratic amplitude modulation to obtain a modulated data stream; and
transmit the modulated data stream via a radio access network or optical fibre communication network.

15. A non-transitory computer readable medium comprising program instructions which, when executed by an apparatus, cause the apparatus to perform at least the following:
demodulate a data stream received by the apparatus via a radio access network or optical fibre communication network, to obtain a demodulated data stream;
demap the demodulated data stream by a soft-input/soft-output maximum a posteriori, SISO-MAP, decoder, or by a multidimensional soft demapper, to obtain a demapped data stream and bit log-likelihood ratios;
subject the demapped data stream to a deinterleaver operation, wherein in the deinterleaver operation bits of the demapped data stream are written sequentially in a column-wise orientation into a deinterleaver matrix, and then the bits are read sequentially in a row-wise manner from the deinterleaver matrix to obtain a deinterleaver output; and
subject the deinterleaver output to a forward error correction, FEC, process by feeding the deinterleaver output and the bit log-likelihood ratios to an N number of identical low-density parity check, LDPC, decoders.
